# EUROPEAN PATENT APPLICATION

(11) **EP 2 450 954 A1**
(43) Date of publication of application: **09.05.2012**
(21) Application number: 11150525.1
(22) Date of filing: 10.01.2011
(51) Int. Cl.: H01L 27/12, H01L 21/77

(54) **Architecture of analog buffer circuit**

(30) Priority: 03.11.2010 US 938867
(71) Applicant: AU Optronics Corp., Hsin-Chu (TW)
(72) Inventor: Chen, Pei-Hua, Hsin-Chu Chinese Taipei (TW); Ting, Yu-Hsin, Hsin-Chu Chinese Taipei (TW); Fu, Chung-Lin, Hsin-Chu Chinese Taipei (TW); Lu, Tsao-Wen, Hsin-Chu Chinese Taipei (TW); Lin, Nan-Ying, Hsin-Chu Chinese Taipei (TW); Hsu, Wei-Chun, Hsin-Chu Chinese Taipei (TW)
(74) Representative: Lang, Christian

(57) **Abstract**

In one aspect of the invention, an analog buffer circuit includes a p-channel field effect transistor (PTFT) and an n-channel field effect transistor (NTFT). Each of the PTFT and NTFT has a source region and a drain region defining a channel region therebetween, formed on a substrate such that the drain regions of the PTFT and the NTFT are in substantial contact with each other, a gate layer formed over and insulated from the corresponding channel region, a source electrode insulated from the gate layer and electrically connected to the corresponding source region, and a common drain electrode insulated from the gate layer and the source electrode, and is electrically connected to the drain regions of both the PTFT and the NTFT through a via defined over the depletion region.

## Description

### FIELD OF THE INVENTION

The present invention relates generally to an analog buffer circuit, and more particularly, to architecture of an analog buffer circuit that utilizes a common electrode connecting to a p-channel thin film transistor (PTFT) and an n-channel thin film transistor (NTFT) to reduce the layout space of the analog buffer circuit on a display panel of using same.

### BACKGROUND OF THE INVENTION

A display panel has a substrate and pixel elements formed thereon. These pixel elements are substantially arranged in the form of a matrix having gate lines in rows and data lines in columns. The display panel is driven by a driving circuit including a gate driver and a data driver. The gate driver generates a plurality of gate signals (scanning signals) sequentially applied to the gate lines for sequentially turning on the pixel elements row-by-row. The data driver generates a plurality of source signals (data signals), i.e., sequentially sampling image signals, simultaneously applied to the data lines in conjunction with the gate signals applied to the gate lines for displaying an image on the panel.

In such a driving circuit, a shift register having multiple stages is utilized in the gate driver to generate the plurality of gate signals for sequentially driving the gate lines. To lower down costs, there have been efforts to integrate the shift register and the gate driver into a display panel. One of the efforts, for example, is to fabricate the shift register and the gate driver on a glass substrate of the panel, namely, the gate driver on array (GOA) arrangement, using amorphous silicon (a-Si) thin film transistors (TFTs), and/or low temperature polycrystalline silicon (LTPS) TFTs.

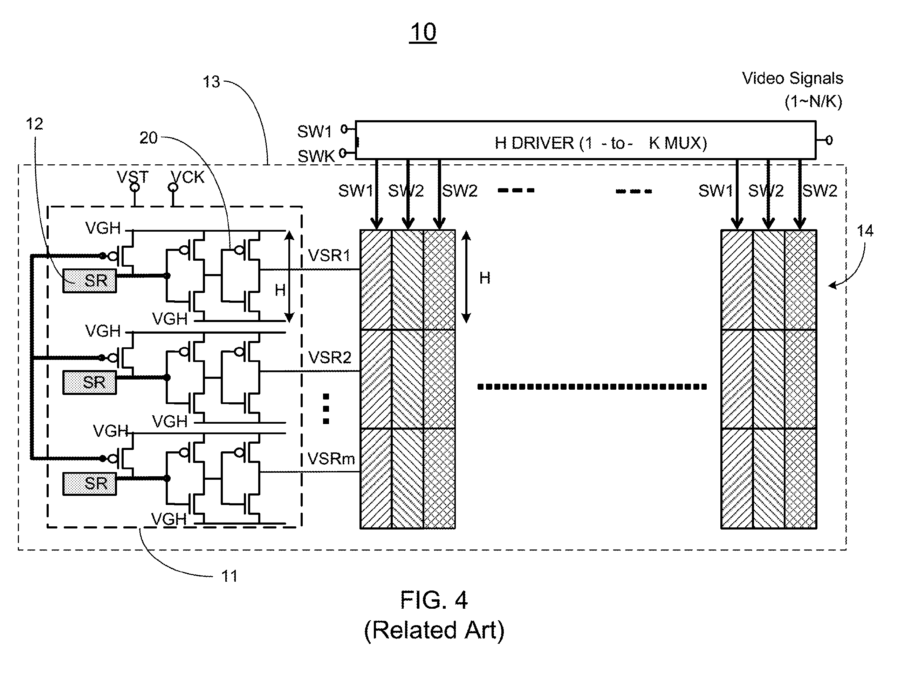

Fig. 4 shows a display panel 10 with GOA architecture 11 of a shift register having a plurality of stages 12 formed thereon. Each stage 12 generates a scanning signal for driving a corresponding pixel row of the display panel 10. In order to enhance the driving ability of the shift register, analog buffers 20 are usually coupled between each stage 12 and a corresponding pixel row 14 for increasing the current thrust of the signal output of the shift register. For the GOA architecture 11, each analog buffer 20 is formed on a substrate 13 having a layout with a width of H, which is substantially the same as the width of a pixel row 14 of the display panel 10. As the high resolution is very demanded for high quality of image display, the shift register is usually designed to a great number of stages. Consequently, the layout space of each stage 12 on the substrate is reduced, whereby the size of the analog buffer 20 is also required be reduced.

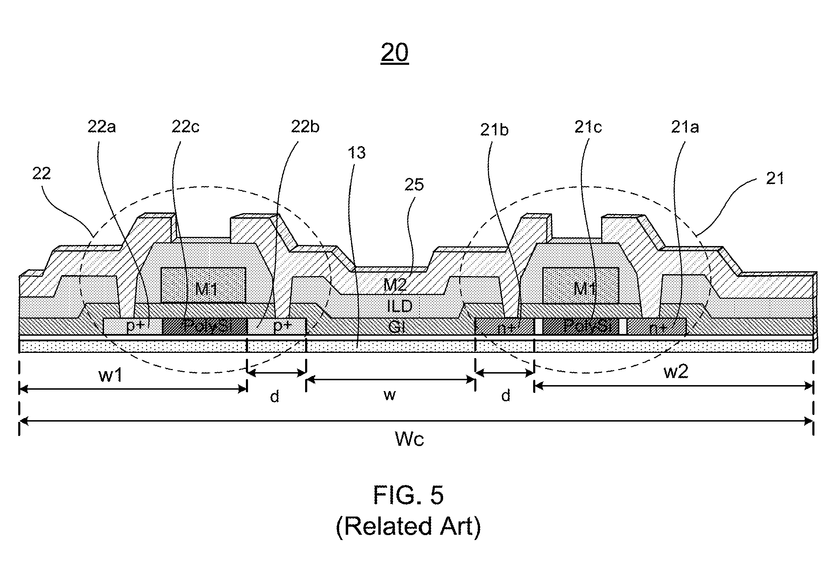

As shown in FIG. 5, the analog buffer 20 includes a n-channel thin film transistor (NTFT) 21 and an p-channel thin film transistor (NTFT) 22. Each of the NTFT 21 and the PTFT 22 has a source region 21a/22a and a drain region 21b/22b defining a channel region 21c/22c therebetween, which are formed on the substrate 13. The drain regions 21b and 22b of the NTFT 21 and the PTFT 22 are spatially separated by a distance, w, the width of the drain region 21b/22b is d, and electrically connected by an interconnect 25. As shown in FIG. 5, the analog buffer 20 has a width of Wc = (w1 + 2d + w + w2). Generally, reduction of the channel width and length of a TFT results in the reduction of the saturated current and deteriorates the stability of the TFT.

Therefore, a heretofore unaddressed need exists in the art to address the aforementioned deficiencies and inadequacies.

### SUMMARY OF THE INVENTION

In one aspect, the present invention relates to an analog buffer circuit. In one embodiment, the analog buffer circuit includes a PTFT and an NTFT.

Each of the PTFT and NTFT comprises a source region and a drain region defining a channel region therebetween, formed on a substrate such that the drain regions of the PTFT and the NTFT are in substantial contact with each other, thereby defining a depletion region in the junction thereof, a first insulation layer formed on the substrate and overlaying the corresponding source, drain and channel regions, a gate layer formed on the first insulation layer and overlapping the corresponding channel region, a second insulation layer formed on the first insulation layer and overlaying the corresponding gate layer, a source electrode formed on the second insulation layer and electrically connected to the corresponding source region, and a common drain electrode formed on the second insulation layer such that the common drain electrode is electrically connected to the drain regions of both the PTFT and the NTFT through a via defined over the depletion region.

In one embodiment, the channel region of each of the PTFT and the NTFT is formed of polycrystalline silicon (poly-Si). The source and drain regions of the PTFT are formed of a p+ doped semiconductor, while the source and drain regions of the NTFT are formed of an n+ doped semiconductor.

In one embodiment, the NTFT further comprises a first n- doped region formed between the source and channel regions and a second n- doped region formed between the channel and drain regions of the NTFT.

In one embodiment, the junction between the drain regions of the PTFT and the NTFT comprises a p-n junction.

In one embodiment, the via has a width larger than that of the depletion region such that the common drain electrode spans the depletion region and is in substantial contact with the drain regions of the PTFT and the NTFT.

In another aspect, the present invention relates to an analog buffer circuit. In one embodiment, the analog buffer circuit includes a PTFT and an NTFT. Each of the PTFT and NTFT comprises a source region and a drain region defining a channel region therebetween, formed on a substrate such that the drain regions of the PTFT and the NTFT are in substantial contact with each other, thereby defining a depletion region in the junction thereof; a gate layer formed over and insulated from the corresponding channel region; a source electrode insulated from the gate layer and electrically connected to the corresponding source region; and a common drain electrode insulated from the gate layer and the source electrode, and is electrically connected to the drain regions of both the PTFT and the NTFT through a via defined over the depletion region. In one embodiment, the junction between the drain regions of the PTFT and the NTFT comprises a p-n junction.

The analog buffer circuit further includes a first insulation layer formed on the substrate and overlaying the source, drain and channel regions of the PTFT and the NTFT, and a second insulation layer formed on the first insulation layer and overlaying the gate layers of the PTFT and the NTFT.

In one embodiment, the channel regions of the PTFT and the NTFT are formed of poly-Si. The source and drain regions of the PTFT are formed of a p+ doped semiconductor. The source and drain regions of the NTFT are formed of an n+ doped semiconductor. The NTFT further comprises a first n- doped region formed between the source and channel regions and a second n- doped region formed between the channel and drain regions.

In one embodiment, the via has a width larger than that of the depletion region such that the common drain electrode spans the depletion region and is in substantial contact with the drain regions of the PTFT and the NTFT.

In yet another aspect, the present invention relates to an analog buffer circuit. In one embodiment, the analog buffer circuit includes a patterned layer formed on a substrate, wherein the patterned layer has a first p+ doped region, a second p+ doped region, a p-channel region formed between the first and second p+ doped regions, a first n+ doped region, a second n+ doped region, and an n-channel region formed between the first and second n+ doped regions, wherein the second p+ doped region and the first n+ doped region are in substantial contact with each other, thereby defining a depletion region in the junction thereof.

The analog buffer circuit also includes a first insulation layer formed on the substrate and overlaying the patterned layer, a first conductive layer having a first portion and a second portion distantly formed on the first insulation layer such that the first and second portions overlap the p-channel and n-channel regions, respectively, and a second insulation layer formed on the first insulation layer and overlaying the first conductive layer.

The analog buffer circuit further includes a second conductive layer having a first portion, a second portion and a third portion distantly formed on the second insulation layer, wherein the first and second portions are electrically connected to the first p+ doped region and the second n+ doped region, and wherein the third portion is electrically connected to the second p+ doped region and the first n+ doped region through a via defined over the depletion region.

Accordingly, the first and second p+ doped regions, the p-channel region, the first portion of the first conductive layer and the first and third portions of the second conductive layer constitute a PTFT. The first and second n+ doped regions, the n-channel region, the second portion of the first conductive layer and the second and third portions of the second conductive layer constitute an NTFT.

In one embodiment, each of the p-channel regions and the n-channel region is formed of poly-Si.

The patterned layer further has a first n- doped region formed between the first n+ doped region and the n-channel region, and a second n- doped region formed between the n-channel region and the second n+ doped region.

In one embodiment, the via has a width larger than that of the depletion region such that the third portion of the second conductive layer spans the depletion region and is in substantial contact with the second p+ doped region and the first n+ doped region.

These and other aspects of the present invention will become apparent from the following description of the preferred embodiment taken in conjunction with the following drawings, although variations and modifications therein may be affected without departing from the spirit and scope of the novel concepts of the disclosure.

### BRIEF DESCRIPTION OF THE DRAWINGS

The accompanying drawings illustrate one or more embodiments of the invention and together with the written description, serve to explain the principles of the invention. Wherever possible, the same reference numbers are used throughout the drawings to refer to the same or like elements of an embodiment, and wherein:
FIG. 1 shows schematically an analog buffer circuit according to one embodiment of the present invention;
FIG. 2 shows schematically a partially perspective view of the analog buffer circuit as shown in FIG. 1;
FIGS. 3A-3F show schematically fabricating processes of the analog buffer circuit as shown in FIG. 1;
FIG. 4 shows schematically a display panel with GOA architecture; and
FIG. 5 shows schematically a conventional analog buffer circuit.

### DETAILED DESCRIPTION OF THE INVENTION

The present invention will now be described more fully hereinafter with reference to the accompanying drawings, in which exemplary embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

It will be understood that when an element or layer is referred to as being "on," "connected to," "coupled to," or "covering" another element or layer, it may be directly on, connected to, coupled to, or covering the other element or layer or intervening elements or layers may be present. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" or "has" and/or "having" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

As used herein, "around", "about" or "approximately" shall generally mean within 20 percent, preferably within 10 percent, and more preferably within 5 percent of a given value or range. Numerical quantities given herein are approximate, meaning that the term "around", "about" or "approximately" can be inferred if not expressly stated.

As used herein, the term "gate driver on array" or its acronym "GOA" refers to a fabricating layout or architecture of a shift register and/or a gate driver on a glass substrate of a display panel, with amorphous silicon (a-Si) TFTs, and/or low temperature polycrystalline silicon (LTPS) TFTs.

As used herein, the terms "comprising," "including," "having," "containing," "involving," and the like are to be understood to be open-ended, i.e., to mean including but not limited to.

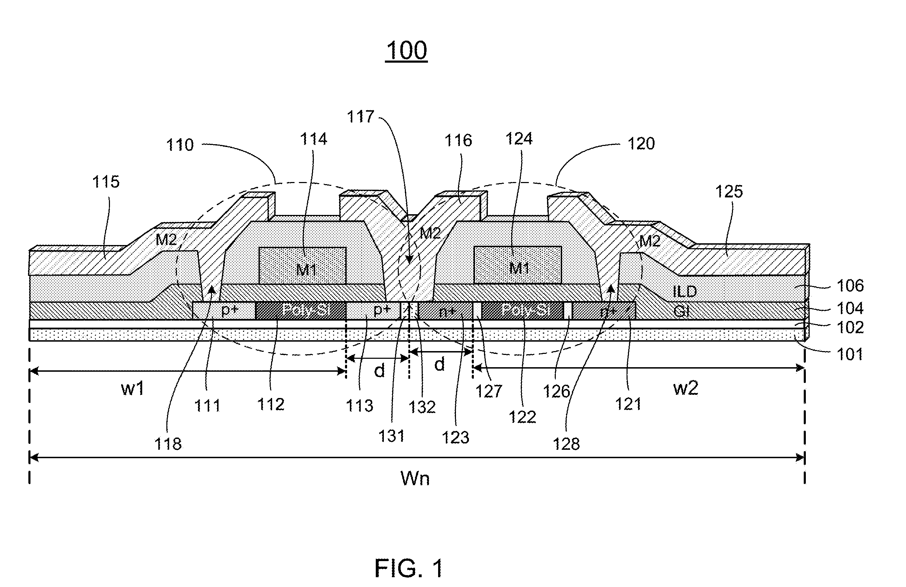

The description will be made as to the embodiments of the present invention in conjunction with the accompanying drawings of FIGS. 1-3. In accordance with the purposes of this invention, as embodied and broadly described herein, this invention, in one aspect, relates to a light emitting device.

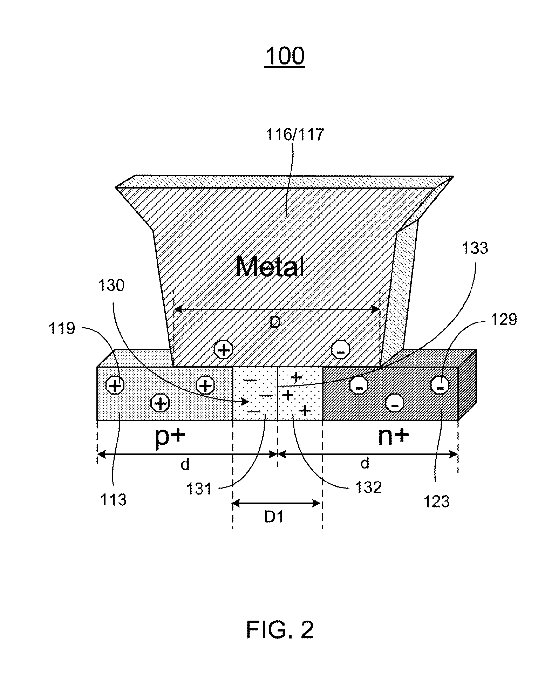

Referring to FIGS. 1 and 2, an analog buffer circuit 100 is shown according to one embodiment of the present invention. The analog buffer circuit 100 includes a PTFT 110 and an NTFT 120 electrically coupled to one another.

The PTFT 110 has a source region 111 and a drain region 113 defining a channel region 112 therebetween, formed on a substrate 101. The NTFT 120 has a source region 121 and a drain region 123 defining a channel region 122 therebetween, formed on the substrate 101 as well. In this embodiment, each of the drain region 113 of the PTFT 110 and the drain region 123 of the NTFT 120 has a width d. For the PTFT 110, the channel region 112 is formed of polycrystalline silicon (poly-Si), while the source region 111 and the drain region 113 are formed of a p+ doped semiconductor. For the NTFT 120, the channel region 122 is formed of poly-Si, while the source region 121 and the drain region 123 are formed of an n+ doped semiconductor. The NTFT 120 may also have a first n- doped region 126 formed between the source and channel regions 121 and 122 and a second n- doped region 127 formed between the channel and drain regions 122 and 123. Additionally, a gate oxide layer 102 may be formed on the substrate 101 before the source, drain and channel regions of the PTFT and the NTFT are formed. The drain regions 113 and 123 of the PTFT 110 and NTFT 120 may be formed to have different widths, and the channel regions 112 and 122 of the PTFT 110 and NTFT 120 may be formed of a same poly-Si, or different poly-Si, or other type of silicon such as a-Si.

Accordingly, the drain regions 113 and 123 of the PTFT 110 and the NTFT 120 are in substantial or very close contact with one another, thereby forming a p-n junction 133 thereof. As a result, a depletion region 130 forms instantaneously across the p-n junction 133, which is an insulating region where the mobile charge carriers have diffused away, or have been forced away by an electric field, and the only elements left in the depletion region 130 are ionized donor or acceptor impurities. The depletion region 130 has a width of D. As shown in FIG. 2, the drain region 123 formed of an n+ doped semiconductor has an excess of free electrons 129 compared to the drain region 113 formed of a p+ doped semiconductor. On the other hand, the p+ doped drain region 113 has an excess of holes 119 compared to the n+ doped drain region 123. Crossing the p-n junction 133, electrons 129 migrate into the p+ doped drain region 113 and holes 119 migrate into the n+ doped drain region 123. Departure of an electron 129 on the n+ doped drain region 123 for the p+ doped drain region 113 leaves a positive donor ion "+" in the n-side 132 of the depletion region 130, and likewise the hole 119 leaves a negative acceptor ion "-" in the p-side 131 of the depletion region 130.

On the top of the source regions 111 and 121, the drain regions 113 and 123 and the channel regions 112 and 122 of the PTFT 110 and the NTFT 120, a first insulation layer 104, also called the gate insulation (GI) layer, is formed and extends onto the substrate 101. The GI layer 104 is formed of an insulative material including, but not limited to, SiNx, SiOx, or SiON.

In addition, each of the PTFT 110 and the NTFT 120 has a gate layer (or electrode) 114/124 is formed on the GI layer 104 and overlapping the corresponding channel region 112/122. The gate layer 114/124 is formed of a conductive material, such as metal or alloy.

On the top of the gate layers 114 and 124, a second insulation layer 106, also called the interlayer dielectric (ILD) layer, is formed, and extends onto the GI layer 104.

A conductive layer having three portions 115, 116 and 125 separated from each other are formed on the second insulation layer 106 as source and drain electrodes of the PTFT 110 and the NTFT 120. As shown in FIG. 1, the first and second portions 115 and 125 of the conductive layer are electrically connected to the source regions 111 and 121 as the source electrodes of the PTFT 110 and the NTFT 120, respectively. Similar to the conventional analog buffer circuit 20 shown in FIG. 5, such electrical connections of the source electrodes 115 and 125 to the corresponding source regions 111 and 121 are implemented by vias 118 and 128, respectively. However, the third portion 116 of the conductive layer is configured as a common/j oint drain electrode of both the PTFT 110 and the NTFT 120, and is electrically connected to the drain regions 113 and 123 of both the PTFT 110 and the NTFT 120 through a via 117 defined over the depletion region 130.

In this embodiment shown in FIGS. 1 and 2, the via 117 has a width, D, which is larger than the width D1 of the depletion region 130. Accordingly, the via portion of the common drain electrode 116 filled in the via 117 spans the depletion region 130 and is in substantial contact with the drain regions 113 and 123 of the PTFT 110 and the NTFT 120, so that the drain regions 113 and 123 of the PTFT 110 and the NTFT 120 are electrically connected together through the via portion of the common drain electrode 116. For such a configuration, no interconnect is needed to electrically connect the drain regions 113 and 123 of the PTFT 110 and the NTFT 120, thereby reducing the size of the analog buffer circuit 100. For example, the analog buffer circuit 100 according to the embodiment shown in FIG. 1 has a width of Wn = (w1 + 2d + w2), which is reduced by at least the distance w, compared to the conventional analog buffer circuit 20 shown in FIG. 5.

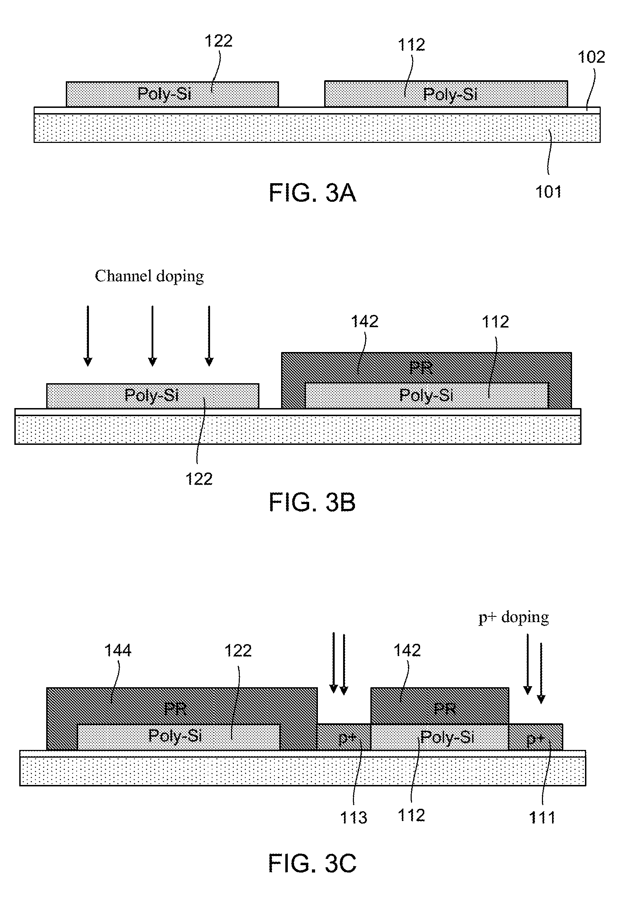

FIGS. 3A-3F show fabrication of the analog buffer circuit 100, by applying a basic CMOS process.

The process starts with the oxidation of a silicon substrate 101, in which a relatively thin silicon dioxide layer 102, also called gate/field oxide, is created on the substrate surface. On top of the thin oxide 102, a layer of poly-Si is deposited. The poly-Si layer is then patterned/etched to define the first portion 112 and a second portion 122 which is separated from the first portion 112, as shown in FIG. 3A.

Then, a photoresist (PR) material is applied to the first portion 112 of the poly-Si layer and exposes the second portion 122 to form a first PR layer 142 covering the first portion 112 of the poly-Si layer, while channel doping is applied to the second portion 122 of the poly-Si layer to define the channel region 122 of the NTFT 120, as shown in FIG. 3B.

Following this step, the PR material is deposited on the second portion 122 of the poly-Si layer to form a second PR layer 144 covering the second portion 122 of the poly-Si layer; the first PR layer 142 covering the first portion 112 of the poly-Si layer is selectively etched to expose the poly-Si surface at the region 111 and 113; and p+ doping is applied to the exposed region 111 and 113 to define the drain region 113 and the source region 111 of the PTFT 110, as shown in FIG. 3C.

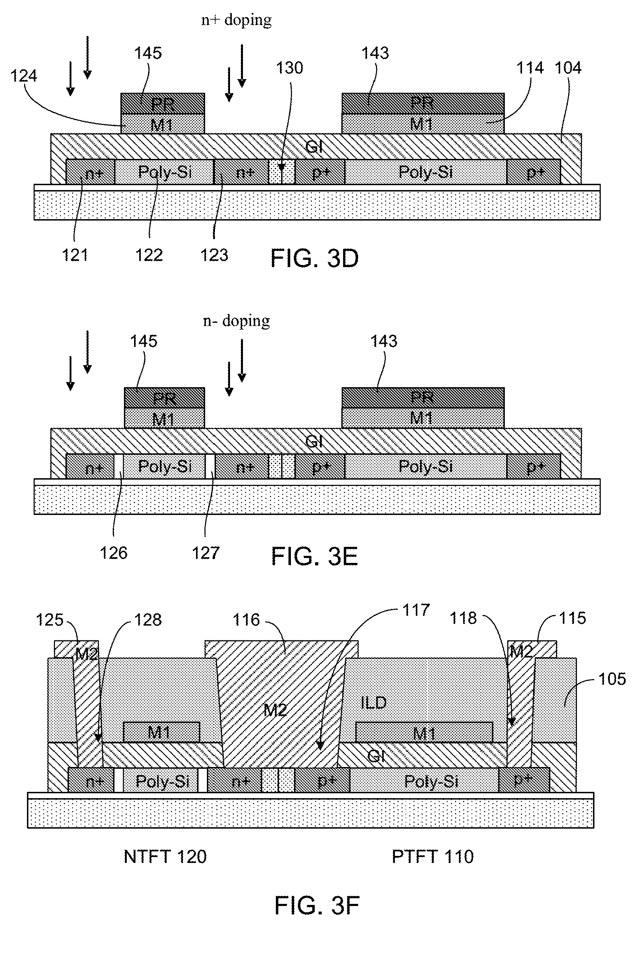

Afterwards, as shown in FIG. 3D, the first PR layer 142 and the second PR layer 144 are removed from the channel portions 112 and 122, respectively, and a GI layer 104 is then deposited thereon. Further, a metallic layer is formed on the GI layer 104 and patterned to have a first gate electrode 114 and a second gate electrode 124 overlapping the corresponding channel regions 112 and 122, respectively. In addition, third PR layer 143 and fourth PR layer 145 are deposited on and cover the first gate electrode 114 and the second gate electrode 124, respectively. After the deposition, n+ doping is applied over the uncovered regions surrounding the second gate electrode 124 and the PR layer 145 to define the source region 121 and the drain region 123 of the NTFT 120. After these steps, the depletion region 130 is formed across the p-n junction 133 of the p+ doped drain region 113 of the PTFT 110 and the n+ doped drain region 123 of the NTFT 110. Further, side etching is performed on both left and right sides of the second gate electrode 124 and the fourth PR layer 145 to uncover regions thereunder, respectively.

Next, n- doping is applied to the uncovered regions to which the n+ doping is applied to define a first n- doped region 126 formed between the source and channel regions 121 and 122 and a second n- doped region 127 formed between the channel and drain regions 122 and 123 of the NTFT 120, as shown in FIG. 3E.

The third and fourth PR layers 143 and 145 are then removed from the gate electrodes 114 and 124, which is followed by the deposition of the ILD layer 105 on the gate electrodes 114 and 124. The ILD layer 105 extends onto and covers the GI layer 104. Then, the structure is patterned from the ILD layer 105 to define a number of connection vias 117, 118 and 128. Of them, the vias 118 and 128 are formed over the source regions 111 and 121 of the PTFT 110 and the NTFT 120, respectively. The via 117 is formed over the depletion region 130 and has a width that is larger than the width of the depletion region 130. In other words, the drain regions 113 and 123 of the PTFT 110 and the NTFT 120 are at least partially exposed. Following the steps, SD sputtering is applied thereon to form the source electrodes 115 and 125 and the drain electrode 116. The source electrodes 115 and 125 are electrically connected to the source region 111 of the PTFT 110 and the source region 121 of the NTFT 120 through the vias 118 and 128, respectively, while the drain electrode 116 is electrically connected to the drain regions 113 and 123 of the PTFT 110 and the NTFT 120 through the via 117, as shown in FIG. 3F.

Briefly, the present invention, among other things, recites an analog buffer circuit that utilizes a common drain electrode connecting to a PTFT and an NTFT so as to reduce the layout space of the analog buffer circuit on a display panel of using same.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to activate others skilled in the art to utilize the invention and various embodiments and with various modifications as are suited to the particular use contemplated. Alternative embodiments will become apparent to those skilled in the art to which the present invention pertains without departing from its spirit and scope. Accordingly, the scope of the present invention is defined by the appended claims rather than the foregoing description and the exemplary embodiments described therein.

## Claims

1. An analog buffer circuit, comprising a p-channel field effect transistor (PTFT) and an n-channel field effect transistor (NTFT), wherein each of the PTFT and NTFT comprises:
a source region and a drain region defining a channel region therebetween, formed on a substrate such that the drain regions of the PTFT and the NTFT are in substantial contact with each other, thereby defining a depletion region in the junction thereof;
a gate layer formed over and insulated from the corresponding channel region;
a source electrode insulated from the gate layer and electrically connected to the corresponding source region; and
a common drain electrode insulated from the gate layer, and is electrically connected to the drain regions of both the PTFT and the NTFT through a via defined over the depletion region.

2. The analog buffer circuit of claim 1, further comprising a first insulation layer formed on the substrate and overlaying the source, drain and channel regions of the PTFT and the NTFT.

3. The analog buffer circuit of claim 2, further comprising a second insulation layer formed on the first insulation layer and overlaying the gate layers of the PTFT and the NTFT.

4. The analog buffer circuit of claim 1, wherein the channel region of each of the PTFT and the NTFT are formed of polycrystalline silicon (poly-Si).

5. The analog buffer circuit of claim 4, wherein the source and drain regions of the PTFT are formed of a p+ doped semiconductor, and wherein the source and drain regions of the NTFT are formed of an n+ doped semiconductor.

6. The analog buffer circuit of claim 5, wherein the NTFT further comprises a first n- doped region formed between the source and channel regions and a second n-doped region formed between the channel and drain regions.

7. The analog buffer circuit of claim 5, wherein the junction between the drain regions of the PTFT and the NTFT comprises a p-n junction.

8. The analog buffer circuit of claim 1, wherein the via has a width larger than that of the depletion region such that the common drain electrode spans the depletion region and is in substantial contact with the drain regions of the PTFT and the NTFT.

9. A method for fabricating an analog buffer circuit, comprising:
forming a patterned layer on a substrate, wherein the patterned layer has a first p+ doped region, a second p+ doped region, a p-channel region formed between the first and second p+ doped regions, a first n+ doped region, a second n+ doped region, and an n-channel region formed between the first and second n+ doped regions, wherein the second p+ doped region and the first n+ doped region are in substantial contact with each other, thereby defining a depletion region in the junction thereof;
forming a first insulation layer on the substrate and overlaying the patterned layer;
forming a first conductive layer having a first portion and a second portion distantly on the first insulation layer such that the first and second portions overlap the p-channel and n-channel regions, respectively;
forming a second insulation layer on the first insulation layer and overlaying the first conductive layer; and
forming a second conductive layer having a first portion, a second portion and a third portion distantly on the second insulation layer, wherein the first and second portions are electrically connected to the first p+ doped region and the second n+ doped region, respectively, and wherein the third portion is electrically connected to the second p+ doped region and the first n+ doped region through a via defined over the depletion region,
wherein the first and second p+ doped regions, the p-channel region, the first portion of the first conductive layer and the first and third portions of the second conductive layer constitute a p-channel thin film transistor (PTFT), and the first and second n+ doped regions, the n-channel region, the second portion of the first conductive layer and the second and third portions of the second conductive layer constitute an n-channel thin film transistor (NTFT).

10. The method for fabricating an analog buffer circuit of claim 9, wherein each of the p-channel regions and the n-channel region is formed of polycrystalline silicon (poly-Si).

11. The method for fabricating an analog buffer circuit of claim 10, wherein the patterned layer further has a first n- doped region formed between the first n+ doped region and the n-channel region, and a second n- doped region formed between the n-channel region and the second n+ doped region.

12. The method for fabricating an analog buffer circuit of claim 9, wherein the via has a width larger than that of the depletion region such that the third portion of the second conductive layer spans the depletion region and is in substantial contact with the second p+ doped region and the first n+ doped region.
